# EUROPÄISCHE PATENTSCHRIFT

(11) **EP 2 499 668 B1**
(45) Veröffentlichungstag und Bekanntmachung des Hinweises auf die Patenterteilung: **03.01.2018**
(21) Anmeldenummer: 10776685.9
(22) Anmeldetag: 11.11.2010
(51) Int. Cl.: H01L 25/16, H01L 33/00, H01L 33/38

(54) **DÜNNFILM-HALBLEITERBAUELEMENT MIT SCHUTZDIODENSTRUKTUR UND VERFAHREN ZUR HERSTELLUNG EINES DÜNNFILM-HALBLEITERBAUELEMENTS**
THIN-FILM SEMICONDUCTOR DEVICE WITH PROTECTION DIODE STRUCTURE AND METHOD FOR PRODUCING A THIN-FILM SEMICONDUCTOR DEVICE
COMPOSANT SEMI-CONDUCTEUR À COUCHE MINCE POURVU D'UNE STRUCTURE À DIODES DE PROTECTION, ET PROCÉDÉ DE PRODUCTION D'UN COMPOSANT SEMI-CONDUCTEUR À COUCHE MINCE

(30) Priorität: 13.11.2009 DE 102009053064
(43) Veröffentlichungstag der Anmeldung: 19.09.2012
(73) Patentinhaber: OSRAM Opto Semiconductors GmbH, 93055 Regensburg (DE)
(72) Erfinder: SCHEUBECK, Manfred, 86497 Horgau-Auerbach (DE); HERRMANN, Siegfried, 94362 Neukirchen (DE)
(74) Vertreter: Epping - Hermann - Fischer
(86) Internationale Anmeldenummer: PCT/EP2010/067278
(87) Internationale Veröffentlichungsnummer: WO 2011/058094

(56) Entgegenhaltungen:
- EP-A2- 1 587 151
- EP-A2- 1 826 834
- WO-A1-2006/054616
- WO-A1-2009/135457
- WO-A2-2006/005062
- US-A1- 2007 210 317
- US-A1- 2008 029 761
- US-A1- 2009 194 777
- US-A1- 2009 242 910

## Beschreibung

Die vorliegende Anmeldung betrifft ein Dünnfilm-Halbleiterbauelement mit einem zur Erzeugung von Strahlung vorgesehenen aktiven Bereich, das eine Schutzdiodenstruktur aufweist.
Bei optoelektronischen Halbleiterbauelementen, beispielsweise Lumineszenzdioden-Halbleiterchips, besteht oftmals die Gefahr, dass diese aufgrund einer elektrostatischen Entladung (electrostatic discharge, ESD) beschädigt oder sogar zerstört werden. Zur Vermeidung einer solchen Schädigung können Schutzdioden elektrisch parallel zur strahlungserzeugenden Diode geschaltet werden, wobei die Durchlassrichtungen der Schutzdiode und der strahlungserzeugenden Diode antiparallel zueinander orientiert sind.
Durch diese Verschaltung fließt bei einer in Sperrrichtung an der strahlungserzeugenden Diode anliegenden Spannung ein elektrischer Strom über die Schutzdiode. Aufgrund des über die Schutzdiode fließenden Stroms wird eine Bestimmung der elektrischen Eigenschaften der strahlungsemittierenden Diodenstruktur in Sperrrichtung erschwert. Insbesondere führt dies zu einer erschwerten Bestimmbarkeit der Polarität, also der Durchlassrichtung der strahlungserzeugenden Diode.

DE102008022942-A stellt ein Dünnfilm-Halbleiterbauelement auf einem Trägerelement dar, welches eine Schutzdiodenstruktur aufweist. Eine zu lösende Aufgabe besteht darin, ein Halbleiterbauelement anzugeben, das vor einer ESD-Schädigung geschützt ist und bei dem gleichzeitig die Polarität der strahlungserzeugenden Diode auf einfache Weise bestimmbar ist. Weiterhin soll ein Verfahren angegeben werden, mit dem ein solches Halbleiterbauelement vereinfacht realisierbar ist.
Diese Aufgaben werden durch die Gegenstände der unabhängigen Patentansprüche gelöst. Ausgestaltungen und Weiterbildungen sind Gegenstand der abhängigen Patentansprüche.
Gemäß einer Ausführungsform weist ein Dünnfilm-Halbleiterbauelement einen Träger und einen Halbleiterkörper mit einer Halbleiterschichtenfolge auf. Die Halbleiterschichtenfolge umfasst einen zur Erzeugung von Strahlung vorgesehenen aktiven Bereich. Der Halbleiterkörper ist mittels eines ersten Kontakt und eines zweiten Kontakts extern elektrisch kontaktierbar. Der Träger weist eine Schutzdiodenstruktur auf, die zum Halbleiterkörper elektrisch parallel verschaltet ist. Die Schutzdiodenstruktur weist eine erste Diode und eine zweite Diode auf. Die erste Diode und die zweite Diode sind bezüglich ihrer Durchlassrichtung zueinander entgegengesetzt elektrisch in Serie verschaltet. Erfindungsgemäß weisen die Schutzdioden in Sperrrichtung des aktiven Bereichs einen Schwellwert auf, der betragsmäßig größer ist als eine Leuchtschwelle des aktiven Bereichs.

Mittels der Schutzdiodenstruktur ist der Halbleiterkörper vor einer elektrostatischen Entladung geschützt. Eine, beispielsweise aufgrund elektrostatischer Aufladung entstehende, elektrische Spannung, die bezogen auf die Durchlassrichtung des aktiven Bereichs in Sperrrichtung anliegt, kann über die Schutzdiodenstruktur abfließen. Eine Schädigung des Halbleiterkörpers wird somit vermieden.
Unter einem Dünnfilm-Halbleiterbauelement wird im Rahmen der vorliegenden Anmeldung insbesondere ein Halbleiterbauelement verstanden, bei dem ein Aufwachssubstrat für die Halbleiterschichtenfolge des Halbleiterkörpers vollständig oder zumindest teilweise entfernt oder gedünnt ist.
Ein Dünnfilm-Halbleiterbauelement, das insbesondere als ein Dünnfilm-Leuchtdioden-Halbleiterchip ausgeführt sein kann, kann sich insbesondere durch mindestens eines der folgenden charakteristischen Merkmale auszeichnen:
- an einer zu einem Trägerelement, zum Beispiel dem Träger, hin gewandten ersten Hauptfläche eines Halbleiterkörpers, der eine Halbleiterschichtenfolge mit einem aktiven Bereich umfasst, insbesondere einer Epitaxieschichtenfolge, ist eine Spiegelschicht aufgebracht oder, etwa als Braggspiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von 20µm oder weniger, insbesondere im Bereich von 10 µm auf; und/oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, d.h. sie weist ein möglichst ergodisch stochastisches Streuverhalten auf. Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben.
Der Träger kann eine dem Halbleiterkörper zugewandte erste Hauptfläche und eine vom Halbleiterkörper abgewandte zweite Hauptfläche aufweisen.
In einer bevorzugten Ausgestaltung ist die Schutzdiodenstruktur in den Träger integriert. Die Schutzdiodenstruktur kann insbesondere vollständig zwischen der ersten Hauptfläche und der zweiten Hauptfläche des Trägers ausgebildet sein. Somit können beide Hauptflächen des Trägers mit der integrierten Schutzdiodenstruktur eben ausgeführt sein. Eine Befestigung des Halbleiterkörpers an dem Träger ist dadurch vereinfacht.
In einer weiteren bevorzugten Ausgestaltung weist die Schutzdiodenstruktur zumindest bei einer in Sperrrichtung des Halbleiterkörpers anliegenden Spannung eine Strom-Spannungs-Charakteristik gemäß einer Zener-Diode in Sperrrichtung auf. Insbesondere können sowohl die erste Diode als auch die zweite Diode gemäß einer Zener-Diode ausgeführt sein.
Mit anderen Worten weist die Strom-Spannungs-Charakteristik der Schutzdiodenstruktur in Sperrrichtung des aktiven Bereichs einen Schwellwert auf. Bei einer Spannung, die betragsmäßig kleiner als der Schwellwert ist, erfolgt kein oder zumindest kein wesentlicher Stromfluss durch die Schutzdiodenstruktur.
Der Schwellwert beträgt vorzugsweise mindestens 1 V, besonders bevorzugt mindestens 2 V. Weiterhin ist der Schwellwert erfindungsgemäß betragsmäßig größer als eine Leuchtschwelle des aktiven Bereichs. Unter einer Leuchtschwelle wird hierbei ein Spannungswert verstanden, ab dem der Halbleiterkörper eine messbare Emission von Strahlung zeigt. Mit anderen Worten ist der Schwellwert vorzugsweise mindestens so groß, dass das Halbleiterbauelement bei einer betragsmäßig dem Schwellwert entsprechenden und in Durchlassrichtung des Halbleiterkörpers anliegenden Spannung Strahlung emittiert.

Bei Anlegen einer Testspannung, die betragsmäßig kleiner ist als der Schwellwert, weist das Dünnfilm-Halbleiterbauelement somit trotz der Integration der Schutzdiodenstruktur in Durchlassrichtung einen höheren Stromfluss auf als in Sperrrichtung bezogen auf den aktiven Bereich. Die Polarität des Dünnfilm-Halbleiterbauelements ist somit vereinfacht bestimmbar.

Weiterhin sind die elektrischen Eigenschaften des aktiven Bereichs des Halbleiterkörpers mittels der in Sperrrichtung anliegenden Testspannung prüfbar.

Mit anderen Worten kann die Schutzdiodenstruktur derart ausgebildet sein, dass sich das Dünnfilm-Halbleiterbauelement bei der angelegten Testspannung wie ein herkömmliches Halbleiterbauelement ohne integrierte Schutzdiode verhält. Bei einer Spannung, die betragsmäßig größer ist als der Schwellwert, zeigt die Schutzdiodenstruktur dagegen nur einen vergleichsweise geringen Widerstand, so dass im Fall einer in Sperrrichtung anliegenden Spannung, die betragsmäßig so groß ist, dass sie eine Schädigung des Halbleiterbauelements verursachen könnte, ein Stromfluss durch die Schutzdiodenstruktur erfolgen kann.

In einer bevorzugten Ausgestaltung ist der erste Kontakt mittels einer ersten Kontaktschicht gebildet, wobei die erste Kontaktschicht an einen ersten Teilbereich des Trägers angrenzt. Weiterhin bevorzugt ist der zweite Kontakt mittels einer zweiten Kontaktschicht gebildet, wobei die zweite Kontaktschicht an einen zweiten Teilbereich des Trägers angrenzt. Sowohl der erste Kontakt als auch der zweite Kontakt können also jeweils mit einem Teilbereich des Trägers elektrisch leitend verbunden sein. Zumindest eine der elektrisch leitenden Verbindungen, vorzugsweise beide elektrisch leitenden Verbindungen, weisen vorzugsweise eine ohmsche oder zumindest näherungsweise ohmsche Strom-Spannungs-Charakteristik, also ein lineares Verhältnis zwischen Spannung und Strom, auf.

Der Träger basiert vorzugsweise auf einem Halbleitermaterial. Halbleitermaterialien eignen sich besonders zur Ausbildung von Zener-Dioden. Silizium eignet sich insbesondere aufgrund seiner breiten Verwendung in der Elektronik und der vergleichsweise kostengünstigen und großflächigen Verfügbarkeit.

Der erste Teilbereich und der zweite Teilbereich des Trägers weisen vorzugsweise einen ersten Leitungstyp auf. Der erste Teilbereich und der zweite Teilbereich sind also bezüglich des Leitungstyps gleichartig ausgebildet. Weiterhin bevorzugt ist zwischen dem ersten Teilbereich und dem zweiten Teilbereich ein weiterer Bereich des Trägers ausgebildet, der einen von dem ersten Leitungstyp des ersten und zweiten Teilbereichs verschiedenen zweiten Leitungstyp aufweist. Beispielsweise können der erste Teilbereich und der zweite Teilbereich n-leitend und der weitere Bereich des Trägers p-leitend ausgebildet sein, so dass sich eine npn-Struktur ergibt. Alternativ kann der Träger auch bezüglich des Leitungstyps invertiert ausgeführt sein, so dass sich entsprechend eine pnp-Struktur ergibt. Ein Übergang zwischen dem ersten Teilbereich und dem weiteren Bereich kann die erste Diode und ein Übergang zwischen dem zweiten Teilbereich und dem weiteren Bereich die zweite Diode der Schutzdiodenstruktur bilden.

In einer bevorzugten Ausgestaltung sind die erste Kontaktschicht und/oder die zweite Kontaktschicht mittels einer Isolationsschicht von dem weiteren Bereich des Trägers elektrisch getrennt. Die erste Kontaktschicht und die zweite Kontaktschicht grenzen also nur im ersten Teilbereich beziehungsweise im zweiten Teilbereich des Trägers an diesen an. Insbesondere kann die Isolationsschicht eine erste Öffnung und eine zweite Öffnung aufweisen, die in Aufsicht auf das Halbleiterbauelement mit dem ersten Teilbereich beziehungsweise dem zweiten Teilbereich überlappt.

In einer bevorzugten Weiterbildung umläuft der erste Teilbereich den zweiten Teilbereich zumindest teilweise. Mit anderen Worten kann der erste Teilbereich rahmenartig ausgeführt sein und den zweiten Teilbereich zumindest teilweise einschließen.

In einer bevorzugten Weiterbildung ist der Halbleiterkörper in lateraler Richtung, also in einer entlang einer Haupterstreckungsebene der Halbleiterschichten des Halbleiterkörpers verlaufenden Richtung, in eine Mehrzahl von Segmenten unterteilt. Bei der Herstellung können diese Segmente aus einer gemeinsamen Halbleiterschichtenfolge für den Halbleiterkörper hervorgehen.

In einer Ausgestaltungsvariante sind die Segmente des Halbleiterkörpers zumindest teilweise unabhängig voneinander extern elektrisch kontaktierbar. Insbesondere kann den unabhängig voneinander extern elektrisch kontaktierbaren Segmenten jeweils zumindest eine, insbesondere gesonderte, Schutzdiodenstruktur zugeordnet sein. Demnach weist der Halbleiterkörper eine Mehrzahl von Segmenten auf, die jeweils vor einer ESD-Schädigung geschützt sind.

In einer alternativen Ausgestaltungsvariante sind die Segmente des Halbleiterkörpers zumindest teilweise elektrisch zueinander in Serie verschaltet. In diesem Fall können die zueinander in Serie verschalteten Segmente eine gemeinsame Schutzdiodenstruktur aufweisen, die elektrisch parallel zu der Serie von Segmenten verschaltet ist.

Die Anordnung der Kontakte, über die im Betrieb des Halbleiterbauelements Ladungsträger von verschiedenen Seiten in den aktiven Bereich des Halbleiterkörpers injiziert werden und dort unter Emission von Strahlung rekombinieren können, kann in weiten Bereichen frei gewählt werden.

Zumindest einer der Kontakte kann auf der dem Halbleiterkörper abgewandten Seite des Trägers angeordnet sein. Der Halbleiterkörper kann in diesem Fall durch zumindest einen Durchbruch in den Träger hindurch mit dem Kontakt elektrisch leitend verbunden sein.

Alternativ oder ergänzend kann zumindest einer der Kontakte auf der dem Halbleiterkörper zugewandten Seite des Trägers angeordnet sein. Insbesondere können beide Kontakte auf der dem Halbleiterkörper zugewandten Seite des Trägers angeordnet sein. Das Halbleiterbauelement ist somit vorderseitig kontaktierbar, wobei unter der Vorderseite insbesondere diejenige Seite verstanden wird, aus der der überwiegende Anteil der im aktiven Bereich erzeugten Strahlung aus dem Halbleiterbauelement austritt.

Bei einem Verfahren zur Herstellung einer Mehrzahl von Halbleiterbauelementen wird gemäß einer Ausführungsform eine Halbleiterschichtenfolge mit einem zur Erzeugung von Strahlung vorgesehenen aktiven Bereich auf einem Aufwachssubstrat abgeschieden. Eine Mehrzahl von Halbleiterkörpern wird aus der Halbleiterschichtenfolge ausgebildet. Das Aufwachssubstrat wird zumindest bereichsweise entfernt. Ein Trägerverbund mit einer Mehrzahl von Schutzdiodenstrukturen wird bereitgestellt. Eine Mehrzahl von Halbleiterkörpern wird relativ zum Trägerverbund positioniert, so dass jeder Schutzdiodenstruktur zumindest ein Halbleiterkörper zugeordnet ist. Eine elektrisch leitende Verbindung der Halbleiterkörper mit den Schutzdiodenstrukturen wird hergestellt. Die Mehrzahl von Halbleiterbauelementen wird fertig gestellt, wobei für jedes Halbleiterbauelement ein Träger aus dem Trägerverbund hervorgeht.

Die Verfahrensschritte müssen hierbei nicht notwendigerweise in der Reihenfolge der obigen Aufzählung durchgeführt werden.

Die Schutzdiodenstruktur kann also bereits in dem Träger ausgebildet sein, bevor die Halbleiterkörper an dem jeweils zugeordneten Träger befestigt werden.

Bereits mit dem Verbinden der Halbleiterkörper mit dem jeweiligen Träger wird somit eine elektrische Verbindung zu der jeweiligen Schutzdiodenstruktur hergestellt, so dass die Halbleiterkörper bei der Herstellung frühzeitig, insbesondere noch bereits vor dem Ausbilden der Halbleiterbauelemente aus dem Trägerverbund, vor einer Schädigung durch elektrostatische Entladung geschützt sind.

In einer bevorzugten Ausgestaltung erfolgt das zumindest bereichsweise Entfernen des Aufwachssubstrats nach dem Herstellen der elektrisch leitenden Verbindung der Halbleiterkörper mit den Schutzdiodenstrukturen. Somit kann das Aufwachssubstrat der mechanischen Stabilisierung der Halbleiterkörper bis zum Befestigen der Halbleiterkörper an dem Trägerverbund dienen. Nach der Befestigung ist eine mechanische Stabilisierung der Halbleiterkörper nicht mehr erforderlich, so dass das Aufwachssubstrat entfernt werden kann.

Davon abweichend kann das Aufwachssubstrat aber auch bereits vor dem Herstellen einer elektrisch leitenden Verbindung der Halbleiterkörper mit den Schutzdiodenstrukturen erfolgen.

Das beschriebene Verfahren ist insbesondere zur Herstellung von Halbleiterbauelementen geeignet, die wie weiter oben beschrieben ausgeführt sind. Im Zusammenhang mit dem Halbleiterbauelement genannte Merkmale können daher auch für das Verfahren herangezogen werden und umgekehrt.

Weitere Merkmale, Ausgestaltungen und Zweckmäßigkeiten ergeben sich aus der folgenden Beschreibung der Ausführungsbeispiele in Verbindung mit den Figuren.

Es zeigen:
die Figuren 1A und 1B ein erstes Ausführungsbeispiel für ein Halbleiterbauelement in schematischer Schnittansicht,
die Figuren 2A und 2B ein zweites Ausführungsbeispiel für ein Halbleiterbauelement in schematischer Aufsicht (Figur 2B) sowie in zugehöriger Schnittansicht (Figur 2A),
Figur 3 eine Strom-Spannungs-Charakteristik für ein Halbleiterbauelement gemäß dem ersten Ausführungsbeispiel im Vergleich zu einem herkömmlichen Bauelement,
Figur 4 ein drittes Ausführungsbeispiel für ein Halbleiterbauelement in schematischer Schnittansicht,
Figur 5 ein viertes Ausführungsbeispiel für ein Halbleiterbauelement in schematischer Schnittansicht,
Figur 6 ein fünftes Ausführungsbeispiel für ein Halbleiterbauelement in schematischer Schnittansicht, und
die Figuren 7A bis 7C ein Ausführungsbeispiel für ein Verfahren zur Herstellung eines Halbleiterbauelements anhand von jeweils in schematischer Schnittansicht dargestellten Zwischenschichten.

Gleiche, gleichartige oder gleich wirkende Elemente sind in den Figuren mit den gleichen Bezugszeichen versehen. Die Figuren sind jeweils schematische Darstellungen und daher nicht unbedingt maßstabsgetreu. Vielmehr können vergleichsweise kleine Elemente und insbesondere Schichtdicken zur Verdeutlichung übertrieben groß dargestellt sein.

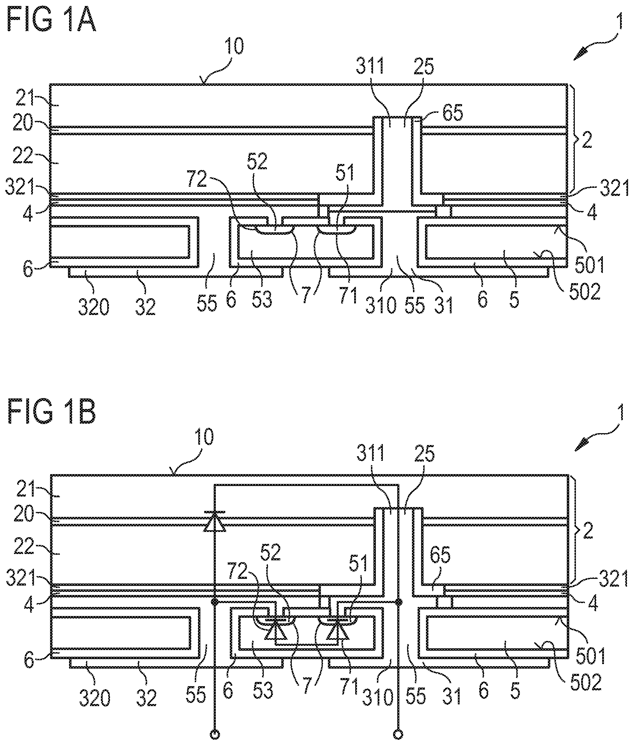

Figur 1A zeigt ein erstes Ausführungsbeispiel für ein Halbleiterbauelement 1, das als ein Dünnfilm-LED-Halbleiterchip ausgeführt ist. Das Halbleiterbauelement 1 weist einen Halbleiterkörper 2 mit einer Halbleiterschichtenfolge auf, die den Halbleiterkörper bildet. Ein Aufwachssubstrat für die Halbleiterschichtenfolge ist vollständig entfernt. Die Halbleiterschichtenfolge umfasst einen aktiven Bereich 20, der zwischen einer ersten Halbleiterschicht 21 und einer zweiten Halbleiterschicht 22 angeordnet ist. Die erste Halbleiterschicht und die zweite Halbleiterschicht sind bezüglich ihres Leitungstyps zweckmäßigerweise voneinander verschieden, so dass diese eine Diodenstruktur ausbilden.

Der Halbleiterkörper 2 ist auf einem Träger 5 angeordnet und mit diesem mechanisch stabil verbunden. Die Verbindung erfolgt mittels einer Verbindungsschicht 4, die zwischen einer dem Halbleiterkörper 2 zugewandten ersten Hauptfläche 501 des Trägers 5 und dem Halbleiterkörper 2 angeordnet ist.

Als Verbindungsschicht eignet sich beispielsweise eine Lotschicht oder eine, insbesondere elektrisch leitfähige, Klebeschicht.

Der Träger 5 weist einen ersten Teilbereich 51 und einen zweiten Teilbereich 52 auf, die jeweils denselben Leitungstyp aufweisen. Beispielsweise können die Teilbereiche jeweils n-leitend ausgebildet sein. Weiterhin umfasst der Träger 5 einen weiteren Bereich 53, der zwischen dem ersten Teilbereich und dem zweiten Teilbereich verläuft und einen vom ersten Leitungstyp verschieden zweiten Leitungstyp aufweist. Somit entsteht zwischen dem ersten Teilbereich 51 und dem weiteren Bereich 53 sowie zwischen dem zweiten Teilbereich 52 und dem weiteren Bereich 53 jeweils ein pn-Übergang. Die dadurch gebildete erste Diode 71 beziehungsweise zweite Diode 72 bilden eine Schutzdiodenstruktur 7, bei der die erste Diode und die zweite Diode bezüglich ihrer Durchlassrichtung zueinander entgegengesetzt elektrisch in Serie verschaltet sind. Weiterhin umfasst das Halbleiterbauelement einen ersten Kontakt 31 und einen zweiten Kontakt 32, die jeweils zur elektrischen externen Kontaktierung des Halbleiterbauelements 1 vorgesehen sind. In dem gezeigten Ausführungsbeispiel sind der erste Kontakt und der zweite Kontakt jeweils auf der dem Halbleiterkörper 2 abgewandten zweiten Hauptfläche 502 des Trägers ausgebildet. Somit ist das Halbleiterbauelement von einer der Strahlungsaustrittsfläche 10 des Halbleiterbauelements abgewandten Seite her elektrisch kontaktierbar.

Der erste Kontakt 31 und der zweite Kontakt 32 sind jeweils mittels einer ersten Kontaktschicht 310 beziehungsweise einer zweiten Kontaktschicht 320 gebildet. Die Kontaktschicht 310 grenzt an den ersten Teilbereich 51 des Trägers 5 an. Weiterhin grenzt die zweite Kontaktschicht 320 des zweiten Kontakts 32 an den zweiten Teilbereich 52 des Trägers an.

Der erste Teilbereich 51 und der zweite Teilbereich 52 können auch derart ausgebildet sein, dass der erste Teilbereich den zweiten Teilbereich, insbesondere vollständig umläuft (nicht explizit dargestellt).

Der Halbleiterkörper weist eine Ausnehmung 25 auf, die sich von der dem Träger 5 zugewandten Seite des Halbleiterkörpers her durch den aktiven Bereich 20 hindurch erstreckt.

Der Halbleiterkörper 2 weist lediglich zur vereinfachten Darstellung nur eine Ausnehmung 25 auf. Je höher die Anzahl die Ausnehmungen ist, desto gleichmäßiger in lateraler Richtung können Ladungsträger über die erste Halbleiterschicht 21 in den aktiven Bereich injiziert werden, so dass aus der Strahlungsaustrittsfläche 10 die Strahlung vergleichsweise homogen austreten kann.

In der Ausnehmung 25 ist eine erste Anschlussschicht 311 ausgebildet, über die die erste Halbleiterschicht 21 mit dem ersten Kontakt 31 elektrisch leitend verbunden ist. Weiterhin ist die erste Anschlussschicht 311 in der Ausnehmung 25 mittels einer weiteren Isolationsschicht 65 von dem aktiven Bereich 20 und der zweiten Halbleiterschicht 22 zur Vermeidung von elektrischen Kurzschlüssen elektrisch isoliert.

Auf der dem Träger 5 zugewandten Seite des Halbleiterkörpers 2 weist die zweite Halbleiterschicht 22 eine zweite Anschlussschicht 321 auf, über die die zweite Halbleiterschicht 22 mit dem zweiten Kontakt 32 elektrisch leitend verbunden ist.

Die erste Anschlussschicht und/oder die zweite Anschlussschicht enthalten vorzugsweise ein Metall oder bestehen aus einem Metall, beispielsweise Ag, Rh, Ti, Pt, Pd, Au oder Al, oder enthalten eine metallische Legierung mit zumindest einem der genannten Metalle. Diese Metalle können auch für die Kontaktschicht 310 und/oder die zweite Kontaktschicht 320 Anwendung finden.

Der Halbleiterkörper 2, insbesondere der aktive Bereich 20, weist vorzugsweise ein III-V-Halbleitermaterial auf.

III-V-Halbleitermaterialien sind zur Strahlungserzeugung im ultravioletten (Inₓ Ga_{y} Al_{1-x-y} N) über den sichtbaren (Inₓ Ga_{y} Al_{1-x-y} N, insbesondere für blaue bis grüne Strahlung, oder Inₓ Ga_{y} Al_{1-x-y} P, insbesondere für gelbe bis rote Strahlung) bis in den infraroten (Inₓ Ga_{y} Al_{1-x-y} As) Spektralbereich besonders geeignet. Hierbei gilt jeweils 0 ≤ x ≤ 1, 0 ≤ y ≤ 1 und x + y ≤ 1, insbesondere mit x ≠ 1, y ≠ 1, x ≠ 0 und/oder y ≠ 0. Mit III-V-Halbleitermaterialien, insbesondere aus den genannten Materialsystemen, können weiterhin bei der Strahlungserzeugung hohe interne Quanteneffizienzen erzielt werden.

Der Träger 5 enthält vorzugsweise ein Halbleitermaterial oder besteht aus einem Halbleitermaterial. Silizium eignet sich besonders als Trägermaterial, insbesondere aufgrund der etablierten Silizium-Technologie und der vergleichsweise kostengünstigen Verfügbarkeit. Es kann aber auch ein anderes Halbleitermaterial, beispielsweise Ge oder GaAs, Anwendung finden.

Der Träger 5 weist weiterhin Durchbrüche 55 auf, die sich von der ersten Hauptfläche 501 bis zu der der ersten Hauptfläche gegenüberliegenden zweiten Hauptfläche 502 des Trägers erstrecken. Über diese Durchbrüche ist der Halbleiterkörper von der dem Halbleiterkörper abgewandten Seite des Trägers her elektrisch kontaktierbar.

Zwischen dem weiteren Bereich 53 des Trägers und der ersten Kontaktschicht 310 sowie der zweiten Kontaktschicht 320 ist eine Isolationsschicht 6 angeordnet. Somit sind der erste Kontakt 31 und der zweite Kontakt 32 jeweils nur über den ersten Teilbereich beziehungsweise den zweiten Teilbereich 51 beziehungsweise 52 mit dem Träger elektrisch leitend mittels einer ohmschen Verbindung verbunden. Hierfür weist die Isolationsschicht 6 Öffnungen auf, in denen die Kontaktschichten 310, 320 an den Träger 5 angrenzen.

Die Isolationsschicht 6 und/oder die weitere Isolationsschicht 65 enthalten vorzugsweise ein Oxid, beispielsweise Siliziumoxid oder Titanoxid, ein Nitrid, beispielsweise Siliziumnitrid, oder ein Oxinitrid, beispielsweise Siliziumoxinitrid, oder bestehen aus einem solchen Material.

Die Strompfade innerhalb des Halbleiterbauelements 1 sind in Figur 1B schematisch dargestellt. Hierbei ist die erste Halbleiterschicht 21 exemplarisch n-leitend und die zweite Halbleiterschicht 22 entsprechend p-leitend ausgebildet. Weiterhin sind der erste und der zweite Teilbereich 51 beziehungsweise 52 des Trägers 5 jeweils n-leitend und der weitere Bereich 53 des Trägers p-leitend ausgeführt.

Bei Anliegen einer positiven Spannung am zweiten Kontakt 32 relativ zum ersten Kontakt 31 wird der aktive Bereich 20 in Durchlassrichtung betrieben, so dass Ladungsträger von unterschiedlichen Seiten über die erste Halbleiterschicht 21 und die zweite Halbleiterschicht 22 in den aktiven Bereich injiziert werden und dort unter Emission von Strahlung rekombinieren. Bei einer in Sperrrichtung anliegenden Spannung kann diese über die Schutzdiodenstruktur 7 abfließen. Die erste Diode 71 und die zweite Diode 72 sind hierbei jeweils als Zener-Dioden ausgeführt, so dass bei einer in Sperrrichtung anliegenden Spannung über die Schutzdiodenstruktur erst ab einem gewissen Schwellwert ein signifikanter Strom fließt. Bei einer Spannung, die betragsmäßig größer ist als die Spannung des Schwellwerts, weist die Schutzdiodenstruktur also nur einen vergleichsweise geringen Widerstand auf, so dass im Falle einer elektrostatischen Aufladung die Ladungsträger über die Schutzdiodenstruktur abfließen können und dadurch die Gefahr einer Schädigung des Halbleiterkörpers weitestgehend vermieden werden kann.

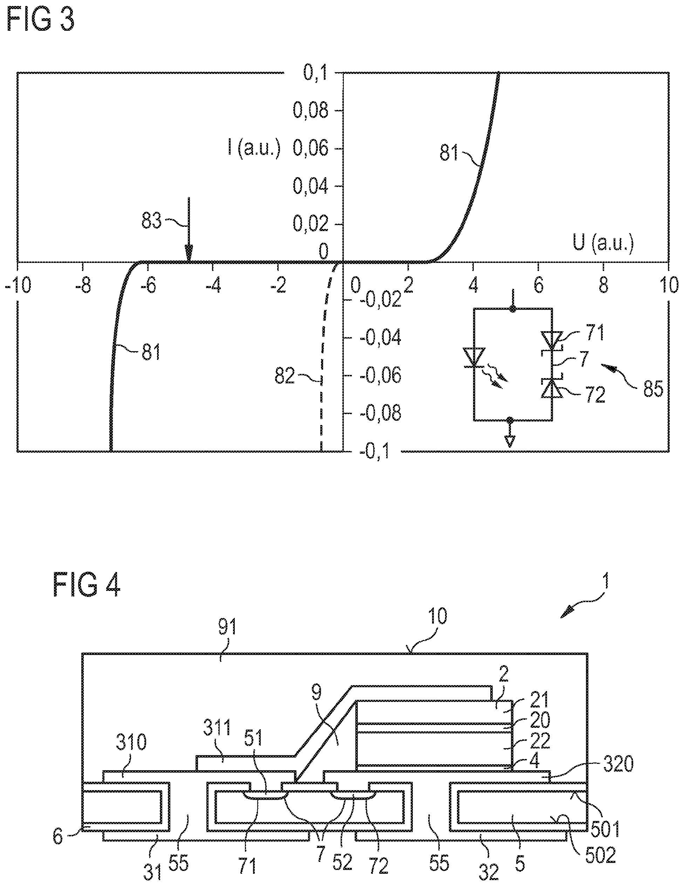

Eine entsprechende Strom-Spannungs-Charakteristik ist schematisch in Figur 3 dargestellt, wobei eine Kurve 81 den Strom I in Abhängigkeit von der angelegten Spannung U für ein Halbleiterbauelement gemäß dem ersten Ausführungsbeispiel darstellt, wobei die Spannung und der Strom jeweils in willkürlichen Einheiten angegeben sind. Im Vergleich dazu zeigt die Kurve 82 eine Strom-Spannungs-Charakteristik für ein herkömmliches Bauelement, bei dem eine einfache Schutzdiode antiparallel zum aktiven Bereich verschaltet ist. Im Unterschied zur Kurve 81 weist diese Kurve bereits bei betragsmäßig vergleichsweise geringen negativen Spannungen einen vergleichsweise niedrigen Widerstand auf. Bei einer Testspannung, die mittels eines Pfeils 83 in der Figur Veranschaulicht ist, würde also bei einem herkömmlichen Bauelement auch in Sperrrichtung des aktiven Bereichs ein sehr hoher Strom fließen, so dass eine Bestimmung der Polarität des Halbleiterbauelements nicht oder nur schwer möglich wäre.

Im Unterschied hierzu kann bei einer Schutzdiodenstruktur mit zwei zueinander entgegengesetzt bezüglich ihrer Durchlassrichtung verschalteten Zener-Dioden bei der Testspannung kein oder zumindest kein wesentlicher Strom über die Schutzdiodenstruktur fließen, so dass eine Bestimmung der Polarität des Bauelements trotz der Integration einer Schutzdiodenstruktur auf einfache Weise erfolgen kann.

Bei betragsmäßig hohen in Sperrrichtung des Halbleiterkörpers 20 anliegenden Spannungen ist der Widerstand der Schutzdiodenstruktur 7 dennoch so gering, dass das Halbleiterbauelement mittels der integrierten Schutzdiodenstruktur effizient vor einer Schädigung aufgrund elektrostatischer Entladung geschützt ist.

Weiterhin zeigt die Figur 3 ein Ersatzschaltbild 85 für die Schutzdiodenstruktur 7 mit der ersten Diode 71 und der zweiten Diode 72, wobei die Schutzdiodenstruktur elektrisch parallel zum aktiven Bereich 20 verschaltet ist.

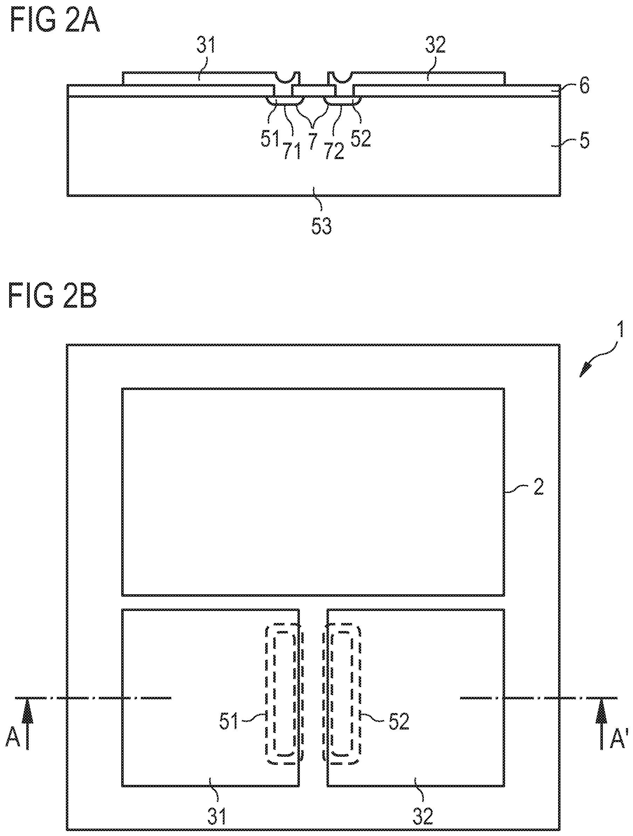

Ein zweites Ausführungsbeispiel für ein Halbleiterbauelement ist in den Figuren 2A und 2B in schematischer Aufsicht sowie in einer schematischen Schnittansicht entlang der Linie AA' dargestellt.

Im Unterschied zum ersten Ausführungsbeispiel sind die Kontakte 31 und 32 jeweils auf der dem Halbleiterkörper 2 zugewandten Seite des Trägers 5 angeordnet. Der Träger 5 kann somit frei von Durchbrüchen 55 ausgebildet sein.

Der erste Kontakt 31, der zweite Kontakt 32 und der Halbleiterkörper 2 sind also in lateraler Richtung nebeneinander angeordnet.

Selbstverständlich kann auch einer der Kontakte auf der dem Halbleiterkörper 2 zugewandten Seite des Trägers und der andere Kontakt auf der dem Halbleiterkörper abgewandten Seite des Trägers angeordnet und, wie im Zusammenhang mit dem ersten Ausführungsbeispiel beschrieben, über Durchbrüche durch den Träger mit dem Halbleiterkörper verbunden sein.

Ein drittes Ausführungsbeispiel für ein Halbleiterbauelement ist in Figur 4 schematisch in Schnittansicht dargestellt. Im Unterschied zum ersten Ausführungsbeispiel weist der Halbleiterkörper 2 keine Ausnehmungen 25 auf. Zur elektrisch leitenden Verbindung der ersten Halbleiterschicht 21 mit dem ersten Kontakt 31 erstreckt sich die erste Anschlussschicht 311 über eine Oberseite der ersten Halbleiterschicht 21 hinaus und verläuft über eine Schräge zur ersten Kontaktschicht 310. Die Schräge ist mittels einer Planarisierungsschicht 9 gebildet, die die erste Anschlussschicht gleichzeitig vom aktiven Bereich 20 und der zweiten Halbleiterschicht 22 elektrisch trennt. Die Planarisierungsschicht ist zweckmäßigerweise elektrisch isolierend ausgeführt. Beispielsweise kann die Planarisierungsschicht BCB (Benzocyclobuten), Siliziumoxid oder Siliziumnitrid enthalten oder aus einem solchen Material bestehen.

Weiterhin weist das Halbleiterbauelement 1 eine Verkapselung 91 auf, die insbesondere den Halbleiterkörper 2 vor einer mechanischen Beschädigung und/oder widrigen äußeren Umwelteinflüssen, etwa Feuchtigkeit, schützt.

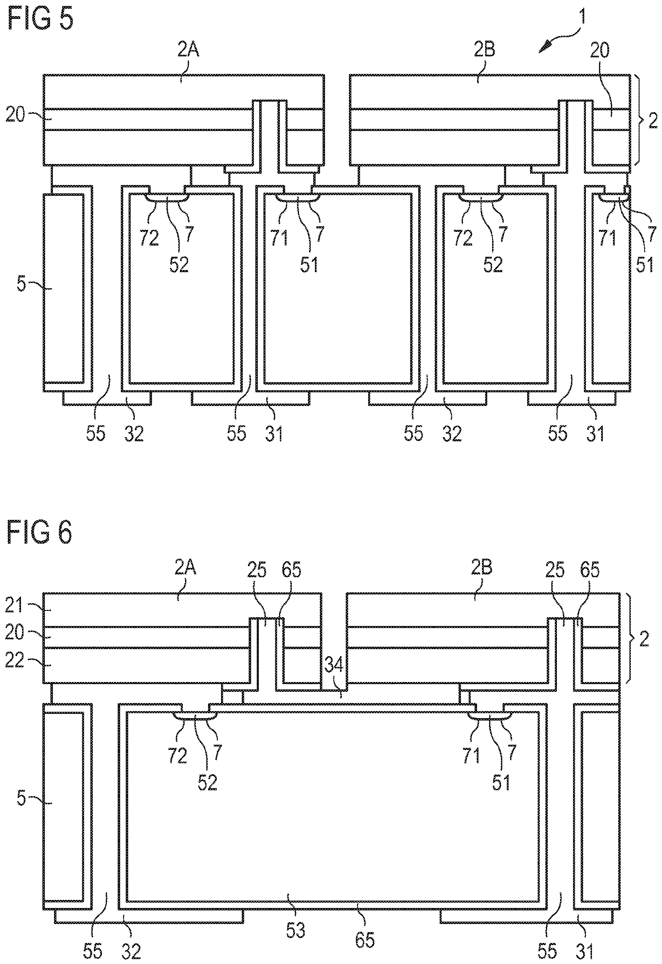

In Figur 5 ist ein viertes Ausführungsbeispiel für ein Halbleiterbauelement schematisch in Schnittansicht dargestellt, wobei dieses Halbleiterbauelement im Wesentlichen wie im Zusammenhang mit Figur 1 beschrieben ausgeführt ist.

Im Unterschied hierzu weist der Halbleiterkörper 2 eine Mehrzahl von Segmenten, in diesem Ausführungsbeispiel lediglich exemplarisch zwei Segmente 2A und 2B, auf. Bei der Herstellung des Halbleiterbauelements gehen die Segmente aus einer gemeinsamen Halbleiterschichtenfolge für den Halbleiterkörper 2 hervor. Beispielsweise können die Segmente durch einen nasschemischen und/oder trockenchemischen Ätzschritt elektrisch voneinander getrennt werden.

Wie im Zusammenhang mit Figur 1 beschrieben, sind die Segmente des Halbleiterkörpers jeweils über einen ersten Kontakt 31 und einen zweiten Kontakt 32 extern elektrisch kontaktierbar. Die Segmente können somit unabhängig voneinander extern elektrisch angesteuert werden. Die Segmente können beispielsweise matrixartig zu einer Bildanzeigevorrichtung ausgebildet sein.

Den Segmenten 2A und 2B ist jeweils eine Schutzdiodenstruktur 7 zugeordnet, die, wie im Zusammenhang mit Figur 1 beschrieben, im Träger ausgebildet ist. Somit ist jedes Segment des Halbleiterkörpers einzeln mittels einer Schutzdiodenstruktur versehen und dennoch auf einfache Weise hinsichtlich seiner elektrischen Eigenschaften in Sperrrichtung prüfbar.

Ein sechstes Ausführungsbeispiel für ein Halbleiterbauelement ist in Figur 6 schematisch in Schnittansicht dargestellt. Dieses Ausführungsbeispiel entspricht im Wesentlichen dem im Zusammenhang mit Figur 5 beschriebenen vierten Ausführungsbeispiel. Im Unterschied hierzu sind die Segmente des Halbleiterkörpers 2A, 2B zueinander elektrisch in Serie verschaltet. Weiterhin ist den Segmenten 2A, 2B eine gemeinsame Schutzdiodenstruktur 7 zugeordnet. Die Verschaltung der Segmente in Serie zueinander erfolgt mittels einer weiteren Anschlussschicht 34. Mittels der weiteren Anschlussschicht besteht eine elektrisch leitende Verbindung der ersten Halbleiterschicht 21 des Segments 2A durch die Ausnehmung 25 hindurch mit der zweiten Halbleiterschicht 22 des zweiten Segments 2B des Halbleiterkörpers 2. Für die weitere Anschlussschicht eignet sich insbesondere eines der im Zusammenhang mit der ersten und zweiten Anschlussschicht genannten Materialien.

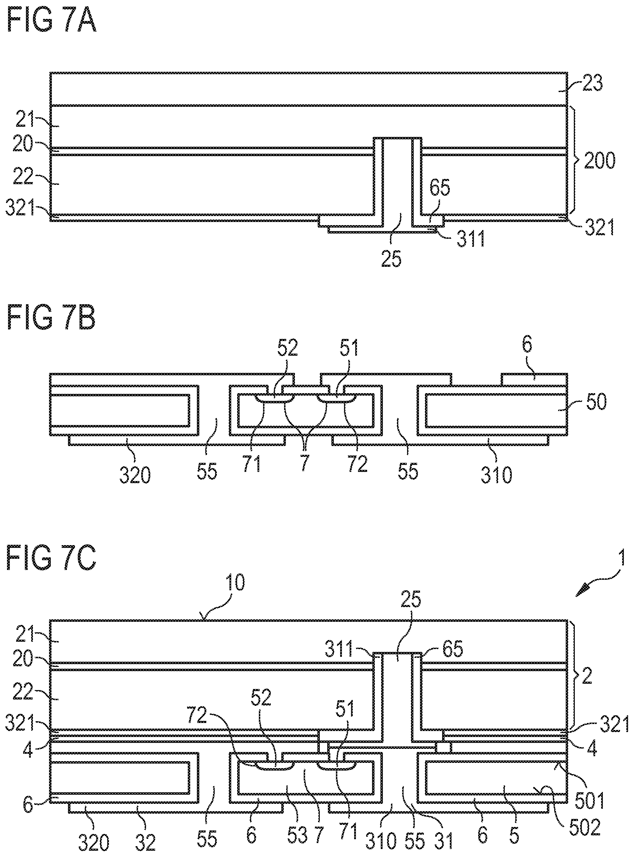

Ein Ausführungsbeispiel für ein Verfahren zur Herstellung eines Halbleiterbauelements ist in den Figuren 7A bis 7C anhand von jeweils in schematischer Schnittansicht gezeigten Zwischenschritten dargestellt.

Die Herstellung ist hierbei lediglich exemplarisch für ein Halbleiterbauelement gezeigt, das gemäß dem im Zusammenhang mit Figur 1A beschriebenen ersten Ausführungsbeispiel ausgebildet ist. Zur vereinfachten Darstellung ist weiterhin nur ein Halbleiterbauelement gezeigt. Mit dem Verfahren kann selbstverständlich eine Vielzahl von Halbleiterbauelementen gleichzeitig hergestellt werden.

Eine Halbleiterschichtenfolge 200 mit einem aktiven Bereich 20, einer ersten Halbleiterschicht 21 und einer zweiten Halbleiterschicht 22 wird auf einem Aufwachssubstrat, vorzugsweise epitaktisch, beispielsweise mittels MOCVD oder MBE, abgeschieden. Von der dem Aufwachssubstrat abgewandten Seite her wird in der Halbleiterschichtenfolge eine Ausnehmung 25 ausgebildet, die sich durch den aktiven Bereich 20 hindurch in die erste Halbleiterschicht 21 hinein erstreckt. Dies kann beispielsweise mittels nasschemischen oder trockenchemischen Ätzens erfolgen. Im Bereich der Ausnehmung 25 wird eine weitere Isolationsschicht 65 ausgebildet, welche die Seitenflächen der Ausnehmung 25 bedeckt. Auf der weiteren Isolationsschicht 65 wird eine erste Anschlussschicht 311 ausgebildet, die mit der ersten Halbleiterschicht 21 elektrisch leitend verbunden ist. Weiterhin wird auf der zweiten Halbleiterschicht 22 eine zweite Anschlussschicht 321 abgeschieden, beispielsweise mittels Aufdampfens oder Aufsputterns.

In Figur 7B ist ein Teil eines Trägerverbunds 50 dargestellt, aus dem ein Träger 5 für den Halbleiterchip hervorgeht.

Der Träger 5 weist Durchbrüche 55 auf, durch die sich jeweils eine erste Kontaktschicht 310 und eine zweite Kontaktschicht 320 hindurch erstrecken.

Wie im Zusammenhang mit Figur 1A beschrieben, sind in dem Träger ein erster Teilbereich 51, ein zweiter Teilbereich 52 und ein weiterer Bereich 53 ausgebildet, die eine Schutzdiodenstruktur 7 mit zwei Zener-Dioden bilden. Die Schutzdiodenstruktur ist über die erste Kontaktschicht 310 und die zweite Kontaktschicht 320 elektrisch kontaktierbar.

Die Schutzdiodenstruktur ist also bereits auf dem Trägerverbund ausgebildet, bevor die Halbleiterkörper an dem Träger befestigt werden.

Der Halbleiterkörper 2 wird relativ zu dem Träger derart positioniert, dass ein elektrischer Kontakt zwischen der ersten Kontaktschicht 310 und der ersten Anschlussschicht 311 beziehungsweise der zweiten Kontaktschicht 320 und der zweiten Anschlussschicht 321 hergestellt werden kann. Die Herstellung dieser Verbindung kann mittels einer Verbindungsschicht 4, etwa einer Lotschicht oder einer elektrisch leitenden Klebeschicht erfolgen.

Nach dem Befestigen der Halbleiterkörper 2 ist das Aufwachssubstrat 23 für die mechanische Stabilisierung des Halbleiterkörpers nicht mehr erforderlich und kann somit entfernt werden. Aufgrund der in den Träger integrierten Schutzdiodenstruktur kann der Halbleiterkörper also bereits während des Entfernens des Aufwachssubstrats vor einer ESD-Schädigung geschützt sein.

Alternativ kann das Aufwachssubstrat auch bereits entfernt werden, bevor die Halbleiterkörper an dem Träger 5 befestigt werden. In diesem Fall sind die Halbleiterkörper 2 vorzugsweise auf einem Hilfsträger befestigt, der nach dem Verbinden der Halbleiterkörper mit dem Träger entfernt werden kann.

Das Entfernen des Aufwachssubstrats kann beispielsweise mechanisch, etwa mittels Schleifens, Läppens oder Polierens und/oder chemisch, beispielsweise mittels nasschemischen oder trockenchemischen Ätzens und/oder mittels kohärenter Strahlung, insbesondere Laserstrahlung, erfolgen.

Ein fertig gestelltes Halbleiterbauelement, das wie im Zusammenhang mit Figur 1A beschrieben ausgeführt ist, ist in Figur 7C dargestellt. Die Vereinzelung des Trägerverbunds in eine Mehrzahl von Trägern 5 mit jeweils zumindest einem Halbleiterkörper 2 kann beispielsweise mechanisch, etwa mittels Spaltens, Ritzens oder Brechens und/oder mittels kohärenter Strahlung, insbesondere Laserstrahlung, erfolgen. Durch das Vereinzeln des Trägerverbunds gehen also Halbleiterbauelemente hervor, in die die Schutzdiodenstruktur bereits integriert ist.

Diese Patentanmeldung beansprucht die Priorität der deutschen Patentanmeldung 10 2009 053 064.9, deren Offenbarungsgehalt hiermit durch Rückbezug aufgenommen wird. Die Erfindung ist nicht durch die Beschreibung anhand der Ausführungsbeispiele beschränkt. Vielmehr ist die Erfindung durch die angehängten Patentansprüche definiert.

## Patentansprüche

1. Dünnfilm-Halbleiterbauelement (1), das einen Träger (5) und einen Halbleiterkörper (2) mit einer Halbleiterschichtenfolge, die einen zur Erzeugung von Strahlung vorgesehenen aktiven Bereich (20) umfasst, aufweist, wobei
- das Dünnfilm-Halbleiterbauelement (1) ein Dünnfilm-Halbleiterchip ist, bei dem ein Aufwachssubstrat für die Halbleiterschichtenfolge (2) entfernt ist;
- der Halbleiterkörper (2) eine Mehrzähl von Ausnenmungen (25) aufweist, die sich von einer dem Träger (5) zugewandten Seite des Halbleiterkörpers her durch den aktiven Bereich (20) hindurch erstrecken;
- der Halbleiterkörper (2) mittels eines ersten Kontakts (31) und eines zweiten Kontakts (32) extern elektrisch kontaktierbar ist; und
- der Träger (5) eine Schutzdiodenstruktur (7) aufweist, die zum Halbleiterkörper (2) elektrisch parallel verschaltet ist;
**dadurch gekennzeichnet, dass**
- die Schutzdiodenstruktur (7) eine erste Diode (71) und eine zweite Diode (72) aufweist;
- die erste Diode (71) und die zweite Diode (72) bezüglich ihrer Durchlassrichtung zueinander entgegengesetzt elektrisch in Serie verschaltet sind; und
- die Schutzdiodenstruktur in Sperrrichtung des aktiven Bereichs einen Schwellwert aufweist, der betragsmäßig größer ist als eine Leuchtschwelle des aktiven Bereichs, wobei eine Leuchtschwelle ein Spannungswert ist, ab dem der Halbleiterkörper eine messbare Emission von Strahlung zeigt.

2. Halbleiterbauelement nach Anspruch 1,
bei dem die Schutzdiodenstruktur in den Träger integriert ist.

3. Halbleiterbauelement nach Anspruch 1 oder 2,
bei dem die Schutzdiodenstruktur zumindest bei einer in Sperrrichtung des Halbleiterkörpers anliegenden Spannung eine Strom-Spannungs-Charakteristik gemäß einer Zener-Diode in Sperrrichtung aufweist.

4. Halbleiterbauelement nach einem der Ansprüche 1 bis 3,
bei dem der erste Kontakt mittels einer ersten Kontaktschicht (310) und der zweite Kontakt mittels einer zweiten Kontaktschicht (320) gebildet sind, wobei die erste Kontaktschicht an einen ersten Teilbereich (51) und die zweite Kontaktschicht an einen zweiten Teilbereich (52) des Trägers angrenzen; und
bei dem der Träger auf einem Halbleitermaterial basiert, wobei der erste Teilbereich und der zweite Teilbereich des Trägers einen ersten Leitungstyp aufweisen und zwischen dem ersten Teilbereich und dem zweiten Teilbereich ein weiterer Bereich (53) des Trägers ausgebildet ist, der einen von dem ersten Leitungstyp verschiedenen zweiten Leitungstyp aufweist.

5. Halbleiterbauelement nach Anspruch 4,
bei dem die erste Kontaktschicht und die zweite Kontaktschicht mittels einer Isolationsschicht (6) von dem weiteren Bereich des Trägers elektrisch getrennt sind.

6. Halbleiterbauelement nach Anspruch 4 oder 5,
bei dem der erste Teilbereich den zweiten Teilbereich zumindest teilweise umläuft.

7. Halbleiterbauelement nach einem der Ansprüche 1 bis 6,
bei dem der Halbleiterkörper in lateraler Richtung in eine Mehrzahl von Segmenten (2A, 2B) unterteilt ist.

8. Halbleiterbauelement nach Anspruch 7,
bei dem die Segmente des Halbleiterkörpers zumindest teilweise unabhängig voneinander extern elektrisch kontaktierbar sind, wobei den unabhängig voneinander extern elektrisch kontaktierbaren Segmenten jeweils zumindest eine Schutzdiodenstruktur zugeordnet ist.

9. Halbleiterbauelement nach Anspruch 7 oder 8,
bei dem die Segmente des Halbleiterkörpers zumindest teilweise elektrisch zueinander in Serie verschaltet sind.

10. Halbleiterbauelement nach einem der Ansprüche 1 bis 9,
bei dem zumindest einer der Kontakte auf der dem Halbleiterkörper abgewandten Seite des Trägers angeordnet ist, wobei der Halbleiterkörper durch zumindest einen Durchbruch (55) in dem Träger hindurch mit dem Kontakt elektrisch leitend verbunden ist.

11. Halbleiterbauelement nach einem der Ansprüche 1 bis 10,
bei dem zumindest einer der Kontakte auf der dem Halbleiterkörper zugewandten Seite des Trägers angeordnet ist.

12. Verfahren zur Herstellung einer Mehrzahl von Dünnfilm-Halbleiterbauelementen (1), die Dünnfilm-Halbleiterchips sind, mit den Schritten:
a) Abscheiden einer Halbleiterschichtenfolge (200) mit einem zur Erzeugung von Strahlung vorgesehenen aktiven Bereich (20) auf einem Aufwachssubstrat (23);
b) Ausbilden einer Mehrzahl von Halbleiterkörpern (2) aus der Halbleiterschichtenfolge;
b') Ausbilden einer Mehrzahl von Ausnehmungen (25), die sich von einer dem Aufwachssubstrat (23) abgewandten Seite her durch den aktiven Bereich (20) hindurch erstrecken;
c) zumindest bereichsweises Entfernen des Aufwachssubstrats (23);
d) Bereitstellen eines Trägerverbunds (50) mit einer Mehrzahl von Schutzdiodenstrukturen (7), wobei die Schutzdiodenstrukturen eine erste Diode und eine zweite Diode aufweisen, die bezüglich ihrer Durchlassrichtung zueinander entgegengesetzt in Serie verschaltet sind, und wobei die Schutzdiodenstrukturen in Sperrrichtung des aktiven Bereichs einen Schwellwert aufweisen, der betragsmäßig größer ist als eine Leuchtschwelle des aktiven Bereichs;
e) Positionieren der Mehrzahl von Halbleiterkörpern (2) derart relativ zum Trägerverbund (50), dass jeder Schutzdiodenstruktur (7) zumindest ein Halbleiterkörper (2) zugeordnet ist;
f) Herstellen einer elektrisch leitenden Verbindung der Halbleiterkörper (2) mit den Schutzdiodenstrukturen (7), wobei die Schutzdiodenstrukturen jeweils zu den Halbleiterkörpern (2) elektrisch parallel verschaltet werden; und
g) Fertigstellen der Mehrzahl von Halbleiterbauelementen, wobei für jedes Halbleiterbauelement ein Träger (5) aus dem Trägerverbund (50) hervorgeht.

13. Verfahren nach Anspruch 12,
bei dem Schritt c) nach Schritt f) durchgeführt wird.

14. Verfahren nach Anspruch 12 oder 13,
mit dem Schritt
h) Vereinzelung des Trägerverbunds zur Herstellung eines Halbleiterbauelements nach einem der Ansprüche 1 bis 11.

## Claims

1. A thin-film semiconductor component (1), which comprises a carrier (5) and a semiconductor body (2) with a semiconductor layer sequence comprising an active region (20) provided for generating radiation, wherein
- the thim-film semiconductor component is a thin-film semiconductor chip, in which a growth substrate for the semiconductor layer sequence (2) is removed;
- the semiconductor body (2) comprises a plurality of recesses (25) extending from a side of the semiconductor body facing the carrier (5) through the active region (20);
- the semiconductor body (2) is externally electrically contactable by means of a first contact (31) and of a second contact (32);
- the carrier (5) comprises a protection diode structure (7), which is connected electrically in parallel to the semiconductor body (2);
- the protection diode structure (7) comprises a first diode (71) and a second diode (72); and
- the first diode (71) and the second diode (72) are electrically series-connected in mutually opposing directions with regard to their forward direction; and
- the protection diode structure comprises a threshold value in the reverse direction of the active region, the threshold value being of a greater absolute value than a luminance threshold of the active region, wherein the luminance threshold is a voltage value, from which the semiconductor body displays a measurable radiation emission.

2. A semiconductor component according to claim 1,
in which the protection diode structure in integrated into the carrier.

3. A semiconductor component according to claim 1 or claim 2, in which, in the case of a voltage applied in the reverse direction of the semiconductor body, the protection diode structure comprises a current-voltage characteristic in accordance with a Zener diode in the reverse direction.

4. A semiconductor component according to any one of claims 1 to 3,
in which the first contact is formed by means of a first contact layer (310) and the second contact by means of a second contact layer (320), wherein the first contact layer adjoins a first sub-region (51) and the second contact layer adjoins a second sub-region (52) of the carrier; and
in which the carrier is based on a semiconductor material, wherein the first sub-region and the second sub-region of the carrier are of a first conduction type and a further region (53) of the carrier is formed between the first sub-region and the second sub-region, which further region is of a second conduction type different from the first conduction type.

5. A semiconductor component according to claim 4,
in which the first contact layer and the second contact layer are electrically isolated from the further region of the carrier by means of an insulation layer (6).

6. A semiconductor component according to claim 4 or 5,
in which the first sub-region at least partially surrounds the second sub-region.

7. A semiconductor component according to any one of claims 1 to 6,
in which the semiconductor body is subdivided in a lateral direction into a plurality of segments (2A, 2B).

8. A semiconductor component according to claim 7,
in which the segments of the semiconductor body are externally electrically contactable at least partially independently of one another, wherein at least one protection diode structure is associated with each of the mutually independently externally electrically contactable segments.

9. A semiconductor component according to claim 7 or 8,
in which the segments of the semiconductor body are at least partially electrically interconnected in series.

10. A semiconductor component according to any one of claims 1 to 9, in which at least one of the contacts is arranged on the side of the carrier remote from the semiconductor body, wherein the semiconductor body is electrically conductively connected to the contact through at least one opening (55) in the carrier.

11. A semiconductor component according to any one of claims 1 to 10, in which at least one of the contacts is arranged on the side of the carrier facing the semiconductor body.

12. A method for producing a plurality of thin-film semiconductor components (1), comprising the steps of:
a) depositing a semiconductor layer sequence (200) with an active region (20) provided for generating radiation on a growth substrate (23);
b) forming a plurality of semiconductor bodies (2) from the semiconductor layer sequence;
b)' forming a plurality of recesses (25) extending from a side facing away from the growth substrate (23) through the active region (20);
c) removing the growth substrate (23) at least in places;
d) providing a carrier assembly (50) with a plurality of protection diode structures (7), wherein the protection diode structures (7) comprises a first diode (71) and a second diode (72) that are electrically series-connected in mutually opposing directions with regard to their forward direction and wherein the protection diode structures comprises a threshold value in the reverse direction of the active region, the threshold value being of a greater absolute value than a luminance threshold of the active region;
e) positioning the plurality of semiconductor bodies (2) relative to the carrier assembly (50) such that at least one semiconductor body (2) is associated with each protection diode structure (7);
f) producing an electrically conductive connection between the semiconductor bodies (2) and the protection diode structures (7), the protection diode structures being in each case electrically connected to the semiconductor bodies (2) in parallel; and
g) finishing the plurality of semiconductor components, wherein one carrier (5) is produced from the carrier assembly (50) for each semiconductor component.

13. A method according to claim 12,
in which step c) is performed after step f).

14. A method according to claim 12 or 13,comprising the step
h) singulating the carrier assembly for producing a semiconductor component according to any one of claims 1 to 11.

## Revendications

1. Dispositif semi-conducteur à film mince (1), qui présente un support (5) et un corps semi-conducteur (2) comprenant une succession de couches semi-conductrices, laquelle comprend une zone active (20) ménagée pour générer un rayonnement,
- le dispositif semi-conducteur à film mince (1) étant une puce semi-conductrice à film mince, dans laquelle un substrat de croissance pour la succession de couches semi-conductrices (2) est enlevé ;
- le corps semi-conducteur (2) présentant une pluralité d'évidements (25) qui, depuis un côté, tourné vers le support (5), du corps semi-conducteur, s'étendent à travers la zone active (20) ;
- le corps semi-conducteur (2) pouvant être mis en contact électrique de manière externe au moyen d'un premier contact (31) et d'un deuxième contact (32) ; et
- le support (5) présentant une structure à diodes de protection (7) qui est électriquement connectée parallèlement au corps semi-conducteur (2), **caractérisé en ce que**
- la structure à diodes de protection (7) présente une première diode (71) et une deuxième diode (72) ;
- **en ce que** la première diode (71) et la deuxième diode (72), quant à leur sens de conduction, sont électriquement connectées en série de manière opposée l'une à l'autre ; et
- **en ce que** la structure à diodes de protection, en sens de blocage de la zone active, présente une valeur seuil dont la valeur est supérieure à un seuil de luminosité de la zone active, un seuil de luminosité étant une valeur de tension à partir de laquelle le corps semi-conducteur indique une émission mesurable du rayonnement.

2. Dispositif semi-conducteur selon la revendication 1,
dans lequel la structure à diodes de protection est intégrée dans le support.

3. Dispositif semi-conducteur selon la revendication 1 ou 2,
dans lequel la structure à diodes de protection, au moins avec une tension présente dans le sens de blocage du corps semi-conducteur, présente une caractéristique courant/tension suivant une diode Zener dans le sens de blocage.

4. Dispositif semi-conducteur selon l'une quelconque des revendications 1 à 3, dans lequel le premier contact est formé au moyen d'une première couche de contact (310) et le deuxième contact au moyen d'une deuxième couche de contact (320), la première couche de contact étant adjacente à une première zone partielle (51) du support et la deuxième couche de contact étant adjacente à une deuxième zone partielle (52) du support ; et
dans lequel le support est à base d'une matière semi-conductrice, la première zone partielle et la deuxième zone partielle du support présentant un premier type de conduction, et une zone supplémentaire (53) du support étant réalisée entre la première zone partielle et la deuxième zone partielle, laquelle zone supplémentaire présente un deuxième type de conduction différent du premier type de conduction.

5. Dispositif semi-conducteur selon la revendication 4,
dans lequel la première couche de contact et la deuxième couche de contact sont électriquement séparées de la zone supplémentaire du support au moyen d'une couche d'isolation (6).

6. Dispositif semi-conducteur selon la revendication 4 ou 5, dans lequel la première zone partielle entoure au moins en partie la deuxième zone partielle.

7. Dispositif semi-conducteur selon l'une quelconque des revendications 1 à 6,
dans lequel le corps semi-conducteur est divisé en direction latérale en une pluralité de segments (2A, 2B).

8. Dispositif semi-conducteur selon la revendication 7,
dans lequel les segments du corps semi-conducteur peuvent être mis en contact électrique de manière externe au moins en partie indépendamment les uns des autres, au moins une structure à diodes de protection étant respectivement attribuée aux segments pouvant être mis en contact électriquement de manière externe au moins en partie indépendamment les uns des autres.

9. Dispositif semi-conducteur selon la revendication 7 ou 8,
dans lequel les segments du corps semi-conducteur sont électriquement connectés en série les uns par rapport aux autres au moins en partie.

10. Dispositif semi-conducteur selon l'une quelconque des revendications 1 à 9,
dans lequel au moins un des contacts est disposé sur le côté du support, détourné du corps semi-conducteur, le corps semi-conducteur étant relié de manière électro-conductrice au contact en traversant au moins un passage (55) situé dans le support.

11. Dispositif semi-conducteur selon l'une quelconque des revendications 1 à 10,
dans lequel au moins un des contacts est disposé sur le côté du support tourné vers le corps semi-conducteur.

12. Procédé de fabrication d'une pluralité de dispositifs semi-conducteurs à film mince (1), lesquels sont des puces semi-conductrices à film mince, comprenant les étapes :
a) séparation d'une succession de couches semi-conductrices (200) comprenant une zone active (20) ménagée pour générer un rayonnement sur un substrat de croissance (23) ;
b) formation d'une pluralité de corps semi-conducteurs (2) à partir de la succession de couches semi-conductrices ;
b') formation d'une pluralité d'évidements (25) qui, à partir d'un côté détourné du substrat de croissance (23), s'étendent à travers la zone active (20) ;
c) retrait au moins en partie du substrat de croissance (23) ;
d) fourniture d'un assemblage porteur (50) comprenant une pluralité de structures à diodes de protection (7), les structures à diodes de protection comprenant une première et une deuxième diodes, lesquelles sont connectées en série de manière mutuellement opposée quant à leur sens de conduction, et les structures à diodes de protection présentant dans le sens de blocage de la zone active une valeur seuil dont la valeur est supérieure à un seuil de luminosité de la zone active ;
e) positionnement de la pluralité de corps semi-conducteurs (2) de manière relative par rapport à l'assemblage porteur (50) de sorte qu'au moins un corps semi-conducteur (2) soit attribué à chaque structure à diodes de protection (7);
f) établissement d'une liaison électro-conductrice des corps semi-conducteurs (2) avec les structures à diodes de protection (7), les structures à diodes de protection (7) étant respectivement électriquement connectées parallèlement aux corps semi-conducteurs (2); et
g) réalisation d'une pluralité de dispositifs semi-conducteurs, un support (5) résultant de l'assemblage porteur (50) pour chaque dispositif semi-conducteur.

13. Procédé selon la revendication 12,
dans lequel l'étape c) est exécutée après l'étape f).

14. Procédé selon la revendication 12 ou 13,
comprenant l'étape
h) séparation de l'assemblage porteur
pour la fabrication d'un dispositif semi-conducteur selon l'une quelconque des revendications 1 à 11.
